# FASCICULE DE BREVET EUROPEEN

(11) **EP 1 594 218 B1**
(45) Date de publication et mention de la délivrance du brevet: **29.08.2007**
(21) Numéro de dépôt: 05103246.4
(22) Date de dépôt: 21.04.2005
(51) Int. Cl.: H02M 7/00

(54) **Variateur électronique de vitesse à agencement modulaire**
Modulare Anordnung einer verstellbaren Geschwindigkeitssteuerung
Electronic speed controller with modular layout

(30) Priorité: 04.05.2004 FR 0404723
(43) Date de publication de la demande: 09.11.2005
(73) Titulaire: Schneider Toshiba Inverter Europe SAS, 27120 Pacy sur Eure (FR)
(72) Inventeur: Barreau, Jérôme, 95800, Courdimanche (FR); Huin, Thierry, 27780, Garenne s/Eure (FR)
(74) Mandataire: Bié, Nicolas

(56) Documents cités:
- EP-A- 0 660 652
- US-A- 5 552 965

## Description

La présente invention se rapporte à un variateur de vitesse électronique à agencement modulaire comprenant, dans un coffret, un onduleur délivrant du courant électrique polyphasé et pourvu d'interrupteurs statiques pilotés par un ensemble électronique de contrôle-commande raccordé à un module d'affichage et dialogue servant au contrôle, commande et à la visualisation disposé en face avant.

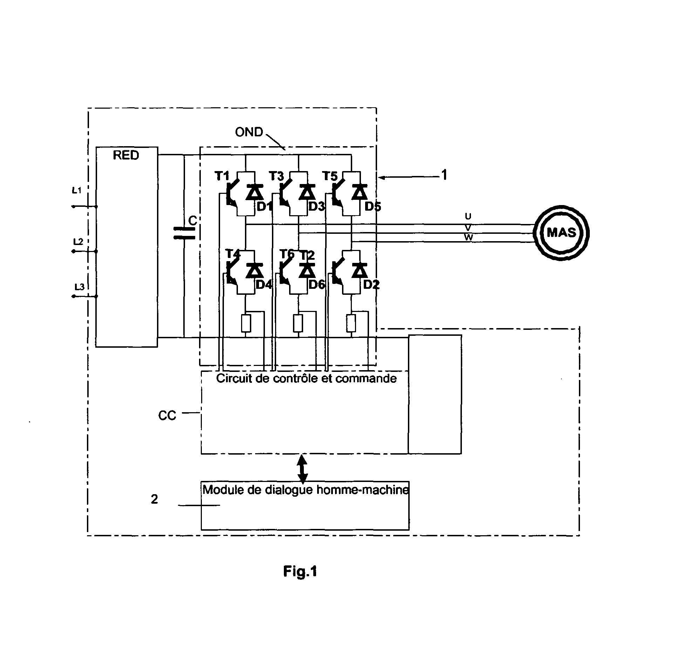

Un variateur de vitesse électronique tel que celui schématisé sur la figure 1 permet de fournir un courant polyphasé réglable à un moteur asynchrone de manière à faire varier sa vitesse. Il comprend un onduleur à interrupteurs électroniques de puissance alimenté, sous une tension continue filtrée, par un redresseur. Cet onduleur délivre du courant alternatif régulé sur les phases du moteur.

La technique de commande des interrupteurs électroniques de puissance est connue sous le nom de Modulation de Largeur d'impulsions (en abrégé MLI et en anglais PWM pour « Pulse Width Modulation »), le but étant de générer une tension aussi proche que possible d'une sinusoïde.

Un ensemble d'affichage et dialogue utilisable par l'opérateur est situé en face avant. Il présente généralement un écran ou des composants de visualisation, des touches de commande et au moins un connecteur de communication permettant de faire communiquer le variateur avec d'autres appareils d'automatisation.

On connaît par le document EP 0660 652 un variateur du type ci-dessus. La compacité d'un tel variateur n'est pas optimisée et ne permet pas d'incorporer simultanément plusieurs cartes optionnelles.

La présente invention a pour but de fournir un variateur électronique de vitesse présentant une compacité optimale même si le nombre de cartes optionnelles varie. Le coffret de taille compacte contient les composants essentiels tandis que les cartes optionnelles, moins courantes, se montent en face avant de manière empilable, derrière la face avant d'affichage et dialogue. La face avant est d'autant plus épaisse que le nombre d'options augmente. L'électronique permet de reconnaître le nombre d'options ainsi que leurs positions.

Le variateur de vitesse électronique selon l'invention est caractérisé par le fait que le coffret présente, en face avant, un plastron de contrôle pourvu d'un connecteur de bus contrôle raccordé au circuit électronique de contrôle-commande disposé à l'arrière et apte à supporter soit le module d'affichage et dialogue se connectant par un connecteur arrière audit connecteur avant soit au moins un module d'option pourvu d'un connecteur traversant dont une partie arrière peut se connecter sur le connecteur avant du plastron ou d'un module d'option et dont une partie avant peut se connecter au connecteur arrière du module d'affichage et dialogue ou d'un module d'option adjacent de manière à constituer une pluralité de modules d'option connectés en série et d'épaisseur variable.

Selon une caractéristique, le module d'option comporte des moyens électroniques pour que l'électronique interne du variateur détecte les modules d'option ajoutés à l'avant du plastron de contrôle.

D'autres caractéristiques et avantages vont apparaître dans la description détaillée qui suit, en se référant à un mode de réalisation donné à titre d'exemple et représenté par les dessins annexés sur lesquels :
- la figure 1 est un schéma fonctionnel du variateur électronique;
- la figure 2 est une vue éclatée du variateur, d'un module d'option intercalaire et du module avant d'affichage et dialogue;
- la figure 3 est une vue dans laquelle le module amovible de d'affichage et dialogue est en position de montage-démontage (sans module d'option intercalaire);
- la figure 4 est une vue dans laquelle le module amovible de d'affichage et dialogue est représenté en position normale d'utilisation (sans module d'option intercalaire);
- la figure 5 est une vue du variateur équipé du module d'affichage et dialogue ainsi que d'un module d'option intercalaire;
- la figure 6 est une vue du variateur équipé du module amovible d'affichage et dialogue ainsi que de deux modules d'option intercalaires;
- la figure 7 est un schéma de l'électronique et du bus de contrôle permettant de reconnaître les options utilisées ;
- la figure 8 est une table de vérité des signaux du schéma de la figure 7.

Le variateur électronique selon l'invention comporte, dans un coffret ou boîtier 1, un onduleur de tension OND qui reçoit la tension de sortie d'un redresseur RED associé à un filtre capacitif C et alimenté par L1, L2, L3.

Cet onduleur de tension est pourvu d'interrupteurs électroniques T1 à T6 associés à des diodes de récupération D1 à D6. Chaque bras de l'onduleur est équipé de deux interrupteurs statiques de puissance associés chacun à une diode de récupération. Les points milieux des couples d'interrupteurs sont reliés aux lignes de phase U, V, W alimentant le moteur électrique MAS. Les interrupteurs électroniques T1 à T6 sont commandés par un circuit de contrôle et de commande CC de manière à délivrer au moteur MAS, sur les lignes de phase U, V, W, une suite d'impulsions modulées en largeur (modulation d'impulsions ou MLI).

Les bornes d'entrée faisant la connexion avec les lignes de phase LI, L2, L3 ainsi que les bornes servant à la connexion aux phases du moteur constituent un bornier qui est connecté à une carte de puissance pourvue des différents interrupteurs électroniques et des diodes. La carte de puissance est associée à un refroidisseur et à des ventilateurs servant à refroidir les interrupteurs électroniques de puissance.

Le variateur peut être paramétré par un module d'affichage et dialogue 2 de type graphique qui est connecté au circuit de commande et de contrôle CC. Ce module d'affichage- dialogue est destiné à se loger en face avant du coffret ou boîtier 1 et comporte, à l'avant, un afficheur 24, des touches 25 de défilement dans les menus ou de modification des valeurs, une touche 26 de sortie des menus et une touche de validation 27 pour entrer dans un menu ou valider la nouvelle valeur choisie. Il présente également un connecteur de communication 29 permettant de connecter le variateur à un réseau d'automatisme ou à un poste de dialogue ou traitement de données. A l'arrière est prévu un connecteur 21 de bus contrôle dont la fonction sera expliquée ci-après. Il comporte en partie haute des organes de verrouillage 22 et en partie basse et à l'arrière des organes de fixation.

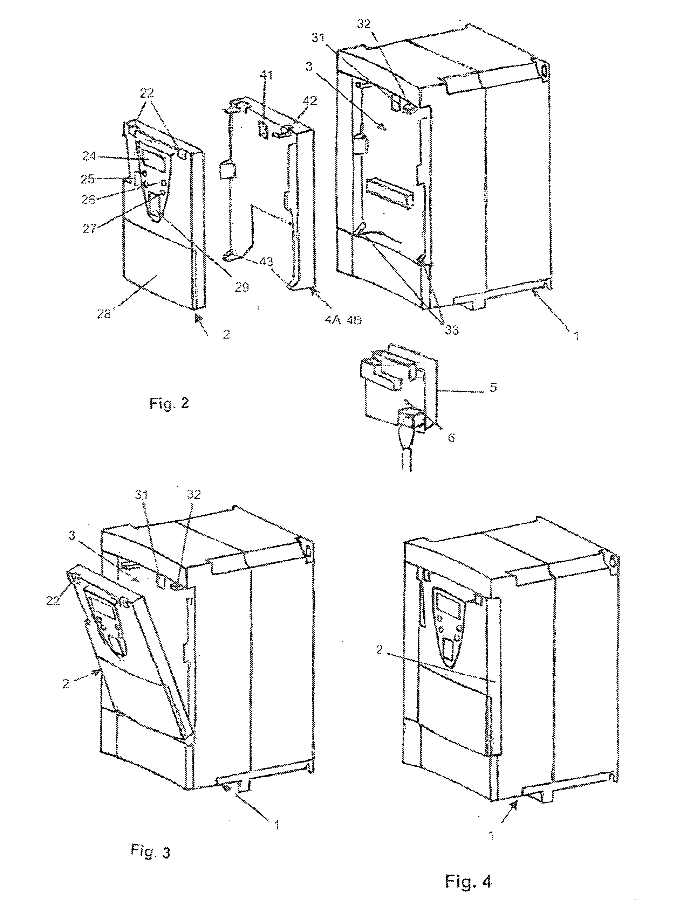

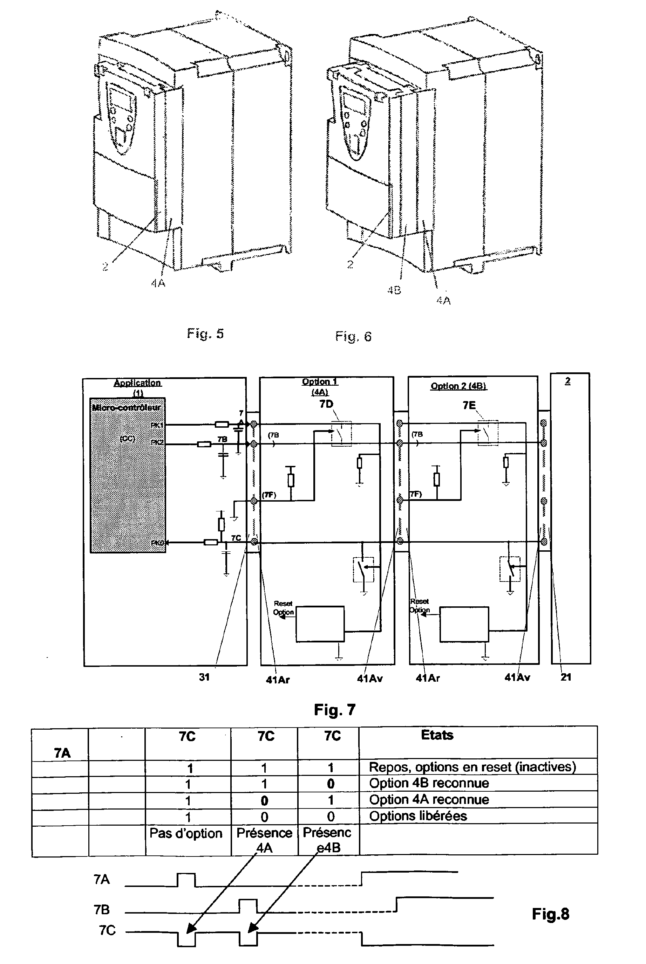

La face avant du coffret 1 est occupée par un plastron de contrôle 3 qui est légèrement en creux par rapport à cette face avant. Ce plastron porte en partie haute des pattes de verrouillage 32 et en partie basse des pattes d'accrochage 33 qui permettent de fixer de manière amovible soit un module d'affichage et dialogue 2 (figures 3 et 4) soit un module d'option 4A (figures 5 et 6). Ces pattes d'accrochage 33 coopèrent avec des moyens d'accrochage conjugués qui sont ménagées à l'arrière du module d'affichage-dialogue 2 ou de chaque module d'option 4. Les pattes de verrouillage 32 coopèrent avec des organes de verrouillage conjugués du module d'affichage-dialogue 2 ou de chaque module d'option 4, respectivement 22 et 42.

Dans le cas où un module d'option 4A est monté directement sur le plastron 3, le dit module 4A peut porter vers l'avant soit le module d'affichage et dialogue 2 (Fig. 5) soit un module d'option supplémentaire 4B (Fig. 6) portant lui même le module d'affichage-dialogue 2.

La coté apparent ou avant du plastron de contrôle 3 présente un connecteur de bus contrôle 31 qui est relié au circuit de contrôle CC .

Sur le plastron 3 on peut rapporter un module électronique additif 6 protégé par un support amovible 5 et se raccordant par un connecteur sur la face avant du plastron. Un tel module additif peut assurer la liaison avec un terminal ou automate.

Un couvercle amovible 28 ménagé sur le module d'affichage-dialogue permet l'accès au module électronique additif 6 et aux connections de câblage.

Chaque module additif d'option 4A, 4B qui se loge entre le plastron de contrôle 3 et le module d'affichage et dialogue 2 présente vers l'arrière un connecteur 41Ar pouvant s'accoupler au connecteur de contrôle 31 du plastron ou 41Av d'un module adjacent et vers l'avant un connecteur 41Av pouvant s'accoupler au connecteur de contrôle 41Ar d'un module adjacent ou 21 du module d'affichage-dialogue 2.

Le circuit représenté à la figure 7 permet de repérer par le bus de contrôle le nombre de modules d'option et leurs positions.

Le circuit représenté à la figure 7 permet de repérer par le bus de contrôle le nombre de modules d'option et leurs positions.

Si le module d'option 4A est monté, la liaison 7F ouvre le contact 7D. Une impulsion positive sur la ligne de bus 7A est détectée sur la ligne 7C par le microcontrôleur du circuit CC.

Si le module d'option 4B est monté, le contact 7E reste fermé. Une impulsion positive sur la ligne 7B est détectée sur la ligne 7C par le microcontrôleur du circuit CC. La table de vérité et le chronogramme ci de la figure 8 illustrent ce cas.

Les signaux 7A et 7B à 0 ont aussi pour fonction de bloquer les microcontrôleurs des cartes options (signal _Reset à 0) et ainsi de pouvoir les libérer l'une après l'autre.

Le principe permet avec des connecteurs options qui sont mécaniquement identiques de repérer la présence et la position d'options. Le type d'option est ensuite reconnu par les communications série entre le microcontrôleur (CC) et les options.

Le bus comporte des liaisons et connexion qui ne sont pas représentées sur la figure 7.

Il est bien entendu que l'on peut, sans sortir du cadre de l'invention, imaginer d'autres variantes et perfectionnements de détail et de même envisager l'emploi de moyens équivalents.

## Revendications

1. Variateur électronique de vitesse comprenant, dans un coffret (1), un onduleur délivrant du courant électrique polyphasé et pourvu d'interrupteurs statiques pilotés par un ensemble électronique de contrôle-commande (CC) raccordé à un module d'affichage et dialogue (2) servant au contrôle, commande et à la visualisation disposé en face avant, **caractérisé par le fait que** le coffret (1) présente, à l'avant, un plastron de contrôle (3) pourvu à l'avant d'un connecteur de bus contrôle (31) raccordé à l'arrière à l'ensemble électronique de contrôle-commande (CC) et apte à supporter soit le module d'affichage et dialogue (2) se connectant par un connecteur arrière audit connecteur de bus (31) soit au moins un module d'option (4A, 4B) pourvu d'un connecteur traversant (41) dont une partie arrière (41Ar) peut se connecter sur le connecteur avant (31 ou 41Av)) du plastron ou d'un module d'option, et dont une partie avant (41Av) peut se connecter au connecteur arrière (21 ou 41Ar) du module d'affichage et dialogue (2) ou d'un module d'option adjacent (4B), de manière à réaliser un ensemble d'épaisseur variable composé d'une pluralité de modules d'option connectés en série et logés entre le plastron de contrôle et le module d'affichage.

2. Variateur de vitesse selon la revendication 1, **caractérisé par le fait que** le module d'option (4A, 4B) comporte des moyens électroniques (7D, 7E) pour que l'électronique interne du variateur détecte les modules d'option (4A, 4B) ajoutés à l'avant du plastron de contrôle.

## Claims

1. Electronic speed controller comprising, in a cabinet (1), an inverter delivering polyphase electric current and provided with static switches operated by an electronic control/command assembly (CC) linked to a display and dialogue module (2) serving for control, command and for visualization, disposed on the front face, **characterized in that** the cabinet (1) exhibits, at the front, a control panel (3) provided at the front with a control bus connector (31) linked at the rear to the electronic control/command assembly (CC) and able to support either the display and dialogue module (2) connected up by a rear connector to the said bus connector (31) or to at least one option module (4A, 4B) provided with a through connector (41) of which a rear part (41Ar) may be connected up to the front connector (31 or 41Av) of the panel or of an option module, and of which a front part (41Av) may be connected to the rear connector (21 or 41Ar) of the display and dialogue module (2) or of an adjacent option module (4B), so as to produce an assembly of variable thickness composed of a plurality of option modules connected in series and housed between the control panel and the display module.

2. Speed controller according to Claim 1, **characterized in that** the option module (4A, 4B) comprises electronic means (7D, 7E) whereby the internal electronics of the controller may detect the option modules (4A, 4B) appended to the front of the control panel.

## Patentansprüche

1. Elektronischer Drehzahlregler, umfassend, in einem Kasten (1), einen Wechselrichter, der mehrphasigen elektrischen Strom ausgibt und mit statischen Schaltern versehen ist, die von einer elektronischen Steueranlage (CC) gesteuert werden, die mit einem auf der Vorderseite angeordneten Anzeige- und Dialogmodul (2) verbunden ist, das der Überwachung, Steuerung und Sichtanzeige dient, **dadurch gekennzeichnet, dass** der Kasten (1) vorne eine Steuerungsplatte (3) aufweist, die vorne mit einem Steuerbus-Steckverbinder (31) versehen ist, der hinten mit der elektronischen Steueranlage (CC) verbunden ist und geeignet ist, entweder das Anzeige- und Dialogmodul (2) zu tragen, das durch einen hinteren Steckverbinder mit dem Bus-Steckverbinder (31) verbunden ist, oder mindestens ein Optionsmodul (4A, 4B), das mit einem durchlaufenden Steckverbinder (41) versehen ist, von dem ein Hinterteil (41Ar) mit dem vorderen Steckverbinder (31 oder 41Av) der Platte oder eines Optionsmoduls verbunden werden kann, und von dem ein Vorderteil (41Av) mit dem hinteren Steckverbinder (21 oder 41Ar) des Anzeige- und Dialogmoduls (2) oder eines benachbarten Optionsmoduls (4B) verbunden werden kann, um eine Einheit variabler Dicke zu ergeben, die aus mehreren Optionsmodulen besteht, die in Reihe geschaltet sind und zwischen der Steuerungsplatte und dem Anzeige- und Dialogmodul aufgenommen werden.

2. Drehzahlregler nach Anspruch 1, **dadurch gekennzeichnet, dass** das Optionsmodul (4A, 4B) elektronische Mittel (7D, 7E) aufweist, damit die interne Elektronik des Reglers die Optionsmodule (4A, 4B), die auf der Vorderseite der Steuerungsplatte hinzugefügt werden, erkennt.
